# EUROPEAN PATENT APPLICATION

(11) **EP 3 376 502 A2**
(43) Date of publication of application: **19.09.2018**
(21) Application number: 18157171.2
(22) Date of filing: 16.02.2018
(51) Int. Cl.: G11C 5/14, G11C 16/30

(54) **VOLTAGE GENERATION CIRCUIT AND SEMICONDUCTOR DEVICE INCLUDING SAME**

(30) Priority: 22.02.2017 KR 20170023736; 18.04.2017 KR 20170049896; 22.12.2017 US 201715853194
(71) Applicant: Samsung Electronics Co., Ltd., Suwon-si, Gyeonggi-do 16677 (KR)
(72) Inventor: SHIN, Ho-young, 15858 Gunpo-si, Gyeonggi-do (KR); OH, Myeong-hee, 13583 Seongnam-si, Gyeonggi-do (KR)
(74) Representative: Kuhnen & Wacker Patent- und Rechtsanwaltsbüro PartG mbB

(57) **Abstract**

A voltage generation circuit (1100) and a semiconductor device including the same are provided. The voltage generation circuit (1100) includes charge pumps (1110, 1120) connected in series, each charge pump (1110, 1120) including a charge transfer transistor (T10, T20), a controller, and a bias circuit. The charge transfer transistor (T10, T20) has a drain, a source that receives a first clock, and a gate that is connected to a first node (SGI, SG2) and that receives a second clock opposite to the first clock. The controller includes a control transistor (T12, T22) having a source connected to the first node (SGI, SG2), a gate coupled to the first clock, and a drain connected to the gate of the control transistor (T12, T22). The bias circuit biases the charge transfer transistor (T10, T20).

## Description

### BACKGROUND

The inventive concept relates to a semiconductor device, and more particularly, to a voltage generation circuit for generating positive and/or negative voltages.

Flash memory is used in a variety of semiconductor devices due to large capacity, low noise, and low power consumption characteristics thereof compared to other non-volatile memory devices. The flash memory performs program and erase operations by generating hot carrier injection (HCI) or Fowler-Nordheim (FN) tunneling in memory cells by using positive and/or negative high voltages. A semiconductor device including the flash memory includes a voltage generation circuit. When an area of the voltage generation circuit in the semiconductor device is large, the area of the semiconductor device is increased.

### SUMMARY

It is an aspect to provide a voltage generation circuit for generating positive and/or negative voltage and capable of reducing an area of the voltage generation circuit and improving charge pump efficiency, and a semiconductor device including the voltage generation circuit.

According to an aspect of one or more exemplary embodiments, there is provided a voltage generation circuit including a plurality of charge pumps connected in series, each of the plurality of charge pumps comprising a charge transfer transistor having a drain, a source that receives a first clock, and a gate that is connected to a first node and that receives a second clock opposite to the first clock; a controller comprising a control transistor having a source connected to the first node, a gate coupled to the first clock, and a drain connected to the gate of the control transistor; and a bias circuit configured to bias the charge transfer transistor.

According to another aspect of one or more exemplary embodiments, there is provided a voltage generation circuit including a first node for receiving a first clock signal through a first capacitor to which the first clock signal is applied; a second node for receiving a second clock signal through a second capacitor to which the second clock signal is applied; a third node for receiving the first clock signal through a third capacitor to which the first clock signal is applied; a first charge transfer transistor for transferring charges from the first node to a fourth node in response to the second clock signal of the second node; a first controller for controlling a voltage level of the second node, in response to the second clock signal of the second node and the first clock signal of the third node; and a first bias circuit for biasing a first P-well of an N type, on which the first charge transfer transistor and the first controller are provided, to a lower voltage between voltages of the first node and the fourth node.

According to yet another aspect of one or more exemplary embodiments, there is provided a voltage generation circuit comprising a first input terminal; a second input terminal; a first output terminal; a second output terminal; a first input/output node; a second input/output node; a charge pump circuit comprising a plurality of pump stages, the charge pump circuit connected between the first input/output node and the second input/output node; a first selector connected to the first input terminal and the second output terminal, and to the first input/output node, the first selector connecting the first input/output node to the first input terminal or the second output terminal in response to a mode signal; and a second selector connected to the first output terminal and the second input terminal, and to the second input/output node, the second selector connecting the second input/output node to the first output terminal or the second input terminal in response to the mode signal.

According to yet another aspect of one or more exemplary embodiments, there is provided a semiconductor device comprising a memory cell array; and a voltage generation circuit configured to provide a positive target voltage and a negative target voltage to the memory cell array, the voltage generation circuit comprising a first charge pump and a second charge pump connected in series, the first charge pump comprising a first charge transfer transistor and a first controller that controls the first charge transfer transistor to perform a charge pump operation in response to a first clock signal and a second clock signal, and the second charge pump comprising a second charge transfer transistor and a second controller that controls the second charge transfer transistor to perform a charge pump operation in response to the first clock signal and the second clock signal, wherein the second clock signal has a same duty cycle as the first clock signal but a phase opposite to a phase of the first clock signal.

According to yet another aspect of one or more exemplary embodiments, there is provided a voltage generation circuit comprising a plurality of charge pumps connected in series, each of the plurality of charge pumps comprising a charge transfer transistor having a drain, a source that receives a first clock through a first capacitor, and a gate that is connected to a first node and that receives a second clock through a second capacitor, the second clock having a logic level opposite to a logic level of the first clock; a controller connected to the first node, the controller receiving the first clock through a third capacitor that is different from the first capacitor and the second capacitor; and a bias circuit configured to bias the charge transfer transistor.

According to yet another aspect of one or more exemplary embodiments, there is provided a voltage generation circuit comprising a first terminal; a second terminal; and a plurality of charge pumps connected in series between the first terminal and the second terminal, each charge pump comprising a charge transfer transistor and a controller that controls the charge transfer transistor, wherein the voltage generation circuit is bi-directional such that, when a negative voltage is applied to the first terminal, a negative voltage path is formed through the plurality of charge pumps and a voltage more negative than the negative voltage is output at the second terminal, and when a positive voltage is applied to the second terminal, a positive voltage path is formed through the plurality of charge pumps and a voltage more positive than the positive voltage is output at the first terminal.

According to yet another aspect of one or more exemplary embodiments, there is provided a voltage generation circuit comprising a plurality of charge pumps connected in series, each of the plurality of charge pumps comprising a charge transfer transistor having a drain, a source that receives a first clock, and a gate that receives a second clock opposite to the first clock; a controller coupled between the gate and the drain of the charge transfer transistor and configured to offset electrons flowing into the gate of the charge transfer transistor using feedback from an output of the charge transfer transistor; and a bias circuit configured to bias the charge transfer transistor.

### BRIEF DESCRIPTION OF THE DRAWINGS

Exemplary embodiments of the inventive concept will be more clearly understood from the following detailed description taken in conjunction with the accompanying drawings in which:
FIG. 1 is a block diagram of a semiconductor device according to an exemplary embodiment;
FIGS. 2 to 10 are diagrams for describing a non-volatile memory device of the semiconductor device of FIG. 1;
FIG. 11 is a circuit diagram of a voltage generation circuit according to an exemplary embodiment;
FIG. 12 is a cross-sectional diagram of a triple-well N-type metal-oxide-semiconductor (MOS) transistor applicable to FIG. 11;
FIG. 13 is a circuit diagram of a voltage generation circuit according to an exemplary embodiment;
FIG. 14 is a timing diagram based on operation of the voltage generation circuit of FIG. 13;
FIG. 15 is a circuit diagram of a voltage generation circuit according to an exemplary embodiment;
FIG. 16 is a cross-sectional diagram of a triple-well N-type MOS transistor applicable to FIG. 15;
FIG. 17 is a circuit diagram of a voltage generation circuit according to an exemplary embodiment;
FIG. 18 is a timing diagram based on operation of the voltage generation circuit of FIG. 17;
FIG. 19 is a circuit diagram of a voltage generation circuit according to an exemplary embodiment;
FIGS. 20 and 21 are circuit diagrams for describing pump stages in a charge pump circuit of the voltage generation circuit of FIG. 19;
FIG. 22 is a waveform diagram for describing an operation of the voltage generation circuit of FIG. 19; and
FIG. 23 is a block diagram of a memory card having a voltage generation circuit according to exemplary embodiments.

### DETAILED DESCRIPTION

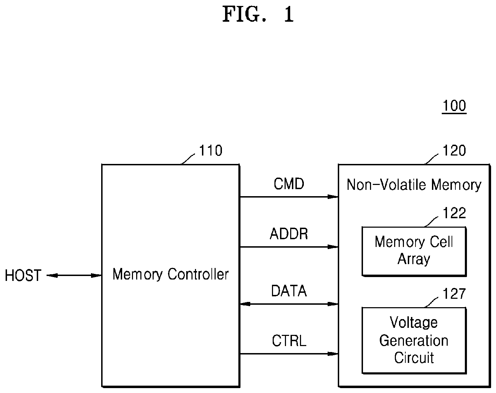

FIG. 1 is a block diagram of a semiconductor device 100 according to an exemplary embodiment.

Referring to FIG. 1, the semiconductor device 100 includes a memory controller 110 and a non-volatile memory device 120. The semiconductor device 100 may be a memory system.

The memory controller 110 may be configured to control the non-volatile memory device 120 in response to a request of a host HOST. The memory controller 110 may write data DATA in the non-volatile memory device 120, or read data DATA stored in the non-volatile memory device 120. To write data DATA in the non-volatile memory device 120, the memory controller 110 may transmit a command CMD, an address ADDR, a control signal CTRL, and the data DATA to the non-volatile memory device 120. To read data DATA stored in the non-volatile memory device 120, the memory controller 110 may transmit a command CMD, an address ADDR, and a control signal CTRL to the non-volatile memory device 120, and receive data DATA in response thereto.

The non-volatile memory device 120 may include non-volatile memory elements such as NAND flash memory, NOR flash memory, phase-change random access memory (PRAM), resistive random access memory (ReRAM), and magnetoresistive random access memory (MRAM).

The non-volatile memory device 120 may write, read, and erase the data DATA in response to signals received from the memory controller 110. The non-volatile memory device 120 includes a memory cell array 122 having memory cells arranged in rows (word lines) and columns (bit lines). Each memory cell may store 1-bit (single-bit) data or M-bit (multi-bit) data (M is an integer equal to or greater than 2). Each memory cell may be configured as a memory cell having a charge storage layer such as a floating gate or a charge trapping layer, or a memory cell having a variable resistor.

The memory cell array 122 may include planar NAND strings having a single-layer array structure (or a two-dimensional (2D) array structure). Alternatively, the memory cell array 122 may be configured to have a multi-layer array structure (or a three-dimensional (3D) array structure). The 3D memory array includes NAND strings provided in a vertical direction in such a manner that at least one memory cell is located on another memory cell. The at least one memory cell may include a charge trapping layer.

The non-volatile memory device 120 includes a voltage generation circuit 127 for generating positive and/or negative high voltages used for program and erase operations. When the non-volatile memory device 120 is a NAND flash memory device, in a program operation, the voltage generation circuit 127 may increase a target voltage to a program voltage, which is a positive high voltage, and provide the program voltage to a selected word line. In an erase operation, the voltage generation circuit 127 may increase a target voltage to an erase voltage, which is a positive high voltage, and provide the erase voltage to a bulk of a selected memory block.

According to an exemplary embodiment, when the non-volatile memory device 120 is a NOR flash memory device, in a program operation, the voltage generation circuit 127 may increase a target voltage to a program voltage, which is a positive high voltage, and provide the program voltage to a selected word line. In an erase operation, the voltage generation circuit 127 may generate a positive high voltage and a negative high voltage, provide the positive high voltage to a bulk of a selected memory block, and provide the negative high voltage to a selected word line.

The memory controller 110 and the non-volatile memory device 120 may be integrated to a single semiconductor device. For example, the memory controller 110 and the non-volatile memory device 120 may be integrated to a single semiconductor device to configure a memory card, PC card (PCMCIA card), compact flash (CF) card, smart media (SM) card (SMC), memory stick, multimedia card (MMC), reduced-size MMC (RS-MMC), MMCmicro, secure digital (SD) card, miniSD, microSD, universal flash storage (UFS), solid state disk/drive (SSD), or the like.

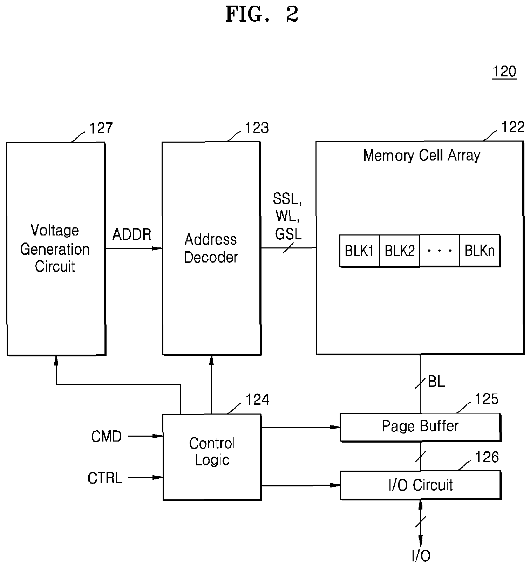

FIG. 2 is a block diagram for describing the non-volatile memory device 120 of FIG. 1. The non-volatile memory device 120 of FIG. 2 is described based on an embedded NAND flash memory device.

Referring to FIG. 2, the non-volatile memory device 120 includes the memory cell array 122, an address decoder 123, a control logic 124, a page buffer 125, an input/output (I/O) circuit 126, and the voltage generation circuit 127.

The memory cell array 122 may be connected to word lines WL, string selection lines SSL, ground selection lines GSL, and bit lines BL. The memory cell array 122 may be connected to the address decoder 123 through the word lines WL, the string selection lines SSL, and the ground selection lines GSL, and connected to the page buffer 125 through the bit lines BL. The memory cell array 122 may include first to n-th memory blocks BLK1 to BLKn.

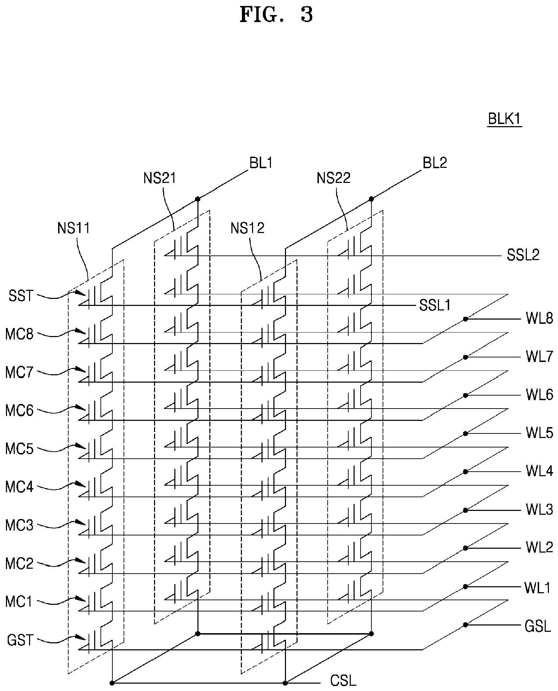

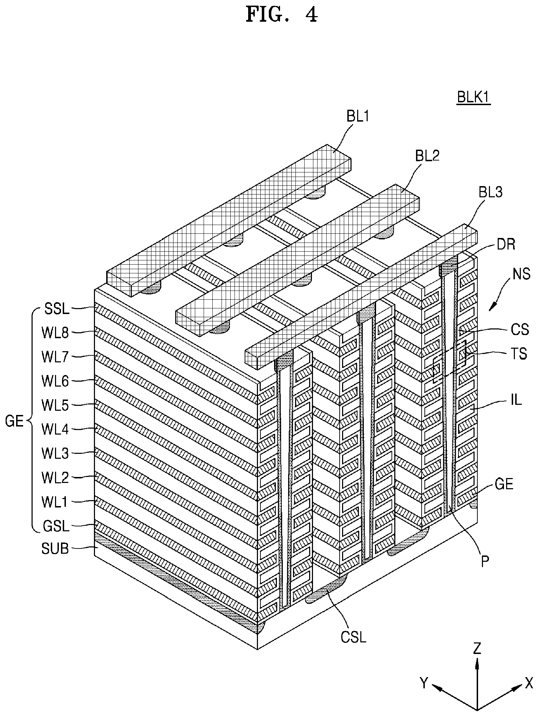

Each of the first to n-th memory blocks BLK1 to BLKn may include a plurality of memory cells and a plurality of selection transistors. The memory cells may be connected to the word lines WL, and the selection transistors may be connected to the string selection lines SSL or the ground selection lines GSL. Each of the first to n-th memory blocks BLK1 to BLKn may include single-level cells for storing 1-bit data, or multi-level cells for storing M-bit data (M is an integer equal to or greater than 3). The memory cells of each of the first to n-th memory blocks BLK1 to BLKn may be stacked in a direction perpendicular to a substrate, thereby obtaining a 3D structure. The memory block structure will be described below with reference to FIGS. 3 and 4.

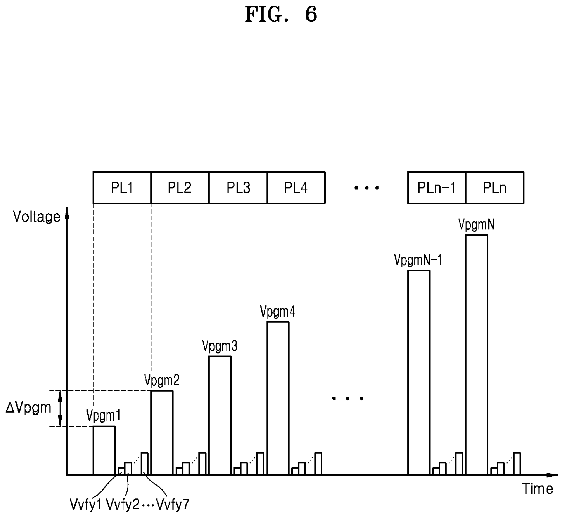

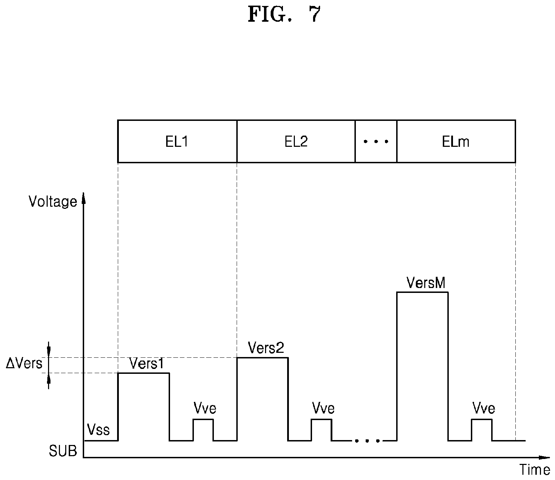

The address decoder 123 may select one of the first to n-th memory blocks BLK1 to BLKn of the memory cell array 122. The address decoder 123 may select one of the word lines WL of the selected memory block. The address decoder 123 may transfer voltages provided from the voltage generation circuit 127, to the word line WL or the selection lines SSL and GSL of the selected memory block. The address decoder 123 may transfer a program voltage of a positive high voltage (e.g., first to N-th program pulses Vpgml to VpgmN of FIG. 6) to the selected word line in an program operation, and transfer an erase voltage of a positive high voltage (e.g., first to M-th erase pulses Vers1 to VersM of FIG. 7) to a bulk of the selected memory block in an erase operation.

The control logic 124 may receive the command CMD and the control signal CTRL from the memory controller 110, and control the address decoder 123, the page buffer 125, and the input/output (I/O) circuit 126 in response to the received signals. The control logic 124 may control the voltage generation circuit 127 for generating various voltage needed to operate the non-volatile memory device 120.

The voltage generation circuit 127 may generate various voltages such as a plurality of selection read voltages, a plurality of non-selection read voltages, a plurality of program pulses, a plurality of pass voltages, and a plurality of erase pulses and provide the generated voltages to the address decoder 123 and the memory cell array 122 under the control of the control logic 124. The voltage generation circuit 127 may generate a positive high voltage corresponding to the first to N-th program pulses Vpgml to VpgmN or the first to M-th erase pulses Vers1 to VersM. According to an exemplary embodiment, when the non-volatile memory device 120 is a NOR flash memory device, the voltage generation circuit 127 may generate a positive high voltage to be provided to a bulk of the selected memory block and a negative high voltage to be provided to the selected word line, in an erase operation.

The page buffer 125 may serve as a write driver or a sense amplifier depending on an operation mode. In a read operation, the page buffer 125 may sense the bit lines BL of the selected memory cell under the control of the control logic 124. The sensed data may be stored in latches included in the page buffer 125. The page buffer 125 may dump the data stored in the latches, to the input/output (I/O) circuit 126 under the control of the control logic 124.

The input/output (I/O) circuit 126 may temporarily store the command CMD, the address ADDR, the control signal CTRL, and the data DATA provided from outside the non-volatile memory device 120 through an input/output line I/O. The input/output (I/O) circuit 126 may temporarily store read data of the non-volatile memory device 120, and output the read data to outside through the input/output line I/O at a designated timing.

FIG. 3 is a circuit diagram showing an example of the memory cell array 122 of FIG. 2. Although a part of the first memory block BLK1 among the first to n-th memory blocks BLK1 to BLKn described above in relation to the memory cell array 122 of FIG. 2 will now be described with reference to FIG. 3, the scope of the inventive concept is not limited thereto and the structure of the first memory block BLK1 may be equally applied to the second to n-th memory blocks BLK2 to BLKn.

The first memory block BLK1 may include a plurality of NAND strings NS11, NS12, NS21, and NS22, first to eighth word lines WL1 to WL8, first and second bit lines BL1 and BL2, ground selection lines GSL, string selection lines SSL1 and SSL2, and common source lines CSL. The NAND strings NS11 and NS21 are provided between the first bit line BL1 and the common source lines CSL, and the NAND strings NS12 and NS22 are provided between the second bit line BL2 and the common source lines CSL. Each NAND string (e.g., NS11) may include a string selection transistor SST, first to eighth memory cells MC1 to MC8, and a ground selection transistor GST, which are connected in series to each other.

FIG. 4 is a perspective view of the first memory block BLK1 of FIG. 3.

Referring to FIG. 4, the memory block BLK1 is provided in a direction perpendicular to a substrate SUB. Although the memory block BLK1 includes two selection lines (e.g., GSL and SSL), eight word lines (e.g., WL1 to WL8), and three bit lines (e.g., BL1 to BL3) in FIG. 4, the numbers of selection lines, eight word lines, and bit lines may be variously changed.

The substrate SUB has a first conductive type (e.g., P type), and the common source lines CSL extending along a first direction (e.g., Y direction) and doped with impurities of a second conductive type (e.g., N type) is provided on the substrate SUB. On a region of the substrate SUB between two adjacent common source lines CSL, a plurality of pillars P sequentially arranged along the first direction and penetrating through a plurality of insulating layers IL along a third direction are provided. On the region between two adjacent common source lines CSL, a charge storage layer CS is provided along exposed surfaces of the insulating layers IL, the pillars P, and the substrate SUB. In addition, on the region between two adjacent common source lines CSL, gate electrodes GE such as the selection lines GSL and SSL and the first to eighth word lines WL1 to WL8 are provided on exposed surfaces of the charge storage layer CS.

Drains or drain contacts DR are individually provided on the pillars P. First to third bit lines BL1 to BL3 extending in a second direction (e.g., X direction) and spaced apart from each other by a certain distance along the first direction are provided on the drains DR. Each pillar P configures a NAND string NS extending along the third direction together with the insulating layers IL, the string and ground selection lines SSL and GSL and the first to eighth word lines WL1 to WL8. The NAND string NS includes a plurality of transistor structures TS. Each of the transistor structures TS may be configured as a charge trap flash (CTF) memory cell.

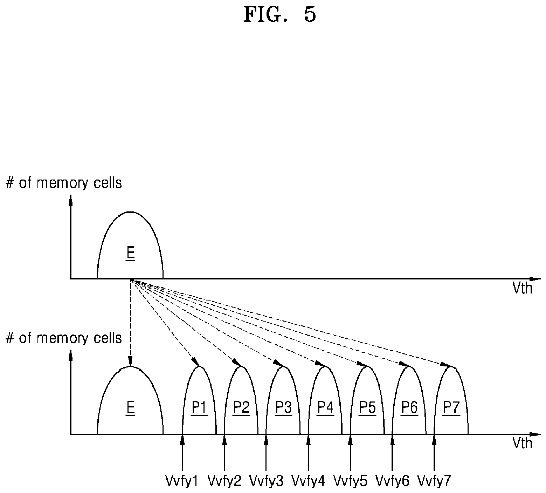

FIGS. 5 and 6 are graphs for describing a program operation of the non-volatile memory device 120 of FIG. 1. FIG. 5 is a graph showing an example of threshold voltage distribution of memory cells illustrated in FIG. 4. FIG. 6 is a graph showing an example of a program method for obtaining the threshold voltage distribution of FIG. 5. In the following description, for brevity of explanation, it is assumed that each memory cell is a triple level cell (TLC). The scope of the inventive concept is not limited thereto and each memory cell may be a multi-level cell (MLC) for storing two bits or four or more bits.

Referring to FIG. 5, a horizontal axis indicates a threshold voltage Vth and a vertical axis indicates the number of memory cells. A plurality of memory cells may have an erase state E. The memory cells having the erase state E may be programmed to have one of the erase state E and first to seventh program states PI to P7.

As shown in FIG. 6, the non-volatile memory device 120 (see FIG. 1) may perform first to n-th program loops PL1 to PLn to program the memory cells to have the erase state E and the first to seventh program states PI to P7. Each of the first to n-th program loops PL1 to PLn may include a program process for applying each of the first to N-th program pulses Vpgml to VpgmN, and a verification process for applying first to seventh verification voltages Vvfy1 to Vvfy7.

The first to N-th program pulses Vpgml to VpgmN are used for a TLC program operation of the non-volatile memory device 120. In the program operation, the voltage generation circuit 127 may generate the first to N-th program pulses Vpgml to VpgmN by setting a target voltage to a positive high voltage corresponding to the first to N-th program pulses Vpgml to VpgmN. The first to N-th program pulses Vpgml to VpgmN may be provided to a selected word line.

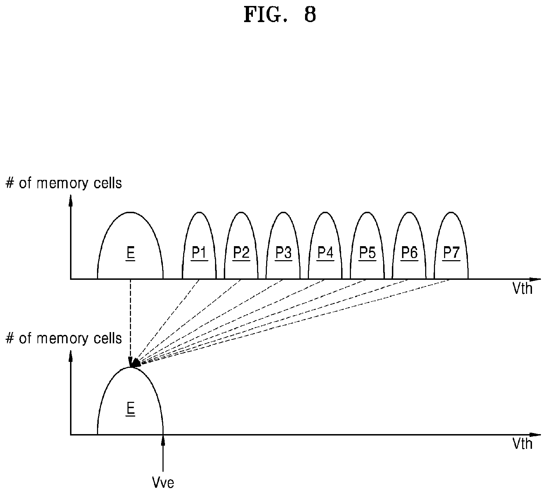

FIGS. 7 and 8 are diagrams for describing an erase operation of the non-volatile memory device 120 of FIG. 1. FIG. 7 is a graph showing an example of a erase operation for obtaining a threshold voltage distribution of FIG. 8.. In FIG. 7, an X axis indicates time and a Y axis indicates a voltage level of the substrate SUB of FIG. 4. In FIG. 8, an X axis indicates a threshold voltage and a Y axis indicates the number of memory cells.

Referring to FIGS. 7 and 8, the memory cells of the first memory block BLK1 may have the erase state E and the first to seventh program states PI to P7 as a result of performing the erase operation of FIG. 7. After performing the erase operation of FIG. 7, the memory cells of the first memory block BLK1 obtain the erase state E having the threshold voltage distribution shown in FIG. 8.

As shown in FIG. 7, the non-volatile memory device 120 may perform first to m-th erase loops EL1, EL2, ... to ELm in such a manner that the memory cells of the first memory block BLK1 have the erase state E. For example, the non-volatile memory device 120 may erase the first memory block BLK1 based on incremental step pulse erase (ISPE) method, in which an erase pulse is higher than an erase pulse of a previous erase loop by a voltage (ΔVers). The voltage (ΔVers) may be predetermined. The non-volatile memory device 120 may erase the first memory block BLK1 by performing the first to m-th erase loops EL1, EL2, ... to ELm. Each of the first to m-th erase loops EL1, EL2, ... to ELm may include an erase process for applying the first to M-th erase pulses Vers1 to VersM to the substrate SUB, and an erase verification process for verifying an erase state of the first memory block BLK1 by using an erase verification voltage Vve.

The first to M-th erase pulses Vers1 to VersM are used for an erase operation of the non-volatile memory device 120. In the erase operation, the voltage generation circuit 127 may generate the first to M-th erase pulses Vers1 to VersM by setting a target voltage to a positive high voltage corresponding to the first to M-th erase pulses Vers1 to VersM. The generated first to M-th erase pulses Vers1 to VersM may be provided to the substrate SUB of the first memory block BLK1.

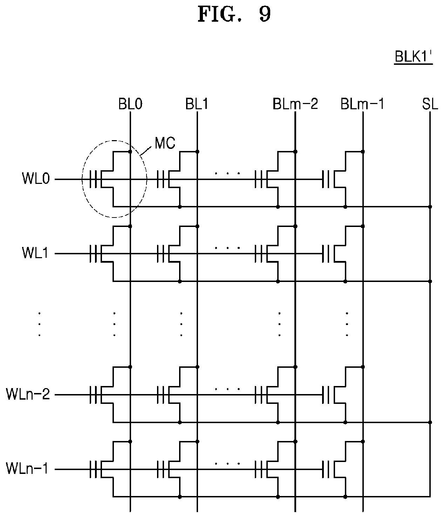

FIG. 9 is a circuit diagram showing an exemplary example of a memory cell array in the non-volatile memory device 120 of FIG. 1. FIG. 9 shows a memory block of an embedded NOR flash memory device. The NOR flash memory device is used as a code storage memory device due to fast access, and commonly used in mobile phones which require to process data at high speed. A part of the first memory block BLK1 among the first to n-th memory blocks BLK1 to BLKn described above in relation to FIG. 2 will now be described with reference to FIG. 9.

Referring to FIG. 9, a first memory block BLK1' includes memory cells MC connected to word lines WL0 to WLn-1 and bit lines BL0 to BLm-1. Drains of the memory cells MC are connected to the bit lines BL0 to BLm-1, and sources of the memory cells MC are connected to a source line SL. A plurality of memory cells MC may be connected in parallel to each of the bit lines BL0 to BLm-1.

In a read operation, a read voltage Vread (e.g., about 5V for single level cells (SLCs)) may be applied to a selected word line WL, and a voltage of about 1V may be applied to a bit line BL of a selected memory cell MC. Depending on a program state of the selected memory cell MC, the memory cell MC is determined to be an on cell or an off cell. The on or off cell may be determined based on the size of a sensing current flowing through the bit line BL.

In a program operation, a program voltage Vpgm (e.g., about 10V) may be applied to the selected word line WL, and a voltage of about 3V to about 5V may be applied to the bit line BL of the selected memory cell MC.

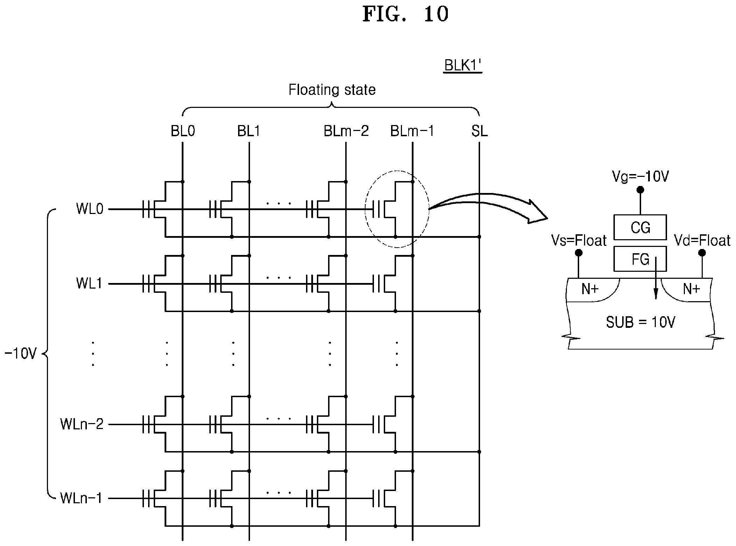

FIG. 10 is a diagram for describing a block erase operation of the memory cell array of FIG. 9.

Referring to FIG. 10, in the block erase operation, the bit lines BL0 to BLm-1 and the source line SL may be biased to a floating state, a negative high voltage (about -10V) may be applied to the word lines WL0 to WLn-1 of the selected first memory block BLK1', and a positive high voltage (about 10V) may be applied to a substrate SUB of the selected first memory block BLK1'.

A positive high voltage and a negative high voltage are used for an erase operation of the first memory block BLK1'. In the erase operation, the voltage generation circuit 127 (see FIG. 1) may generate and provide a positive high voltage to the substrate SUB of the selected first memory block BLK1', and generate and provide a negative high voltage to the word lines WL0 to WLn-1 of the selected first memory block BLK1'. As such, the non-volatile memory device 120 may include different high voltage generation circuits for generating the positive high voltage and the negative high voltage.

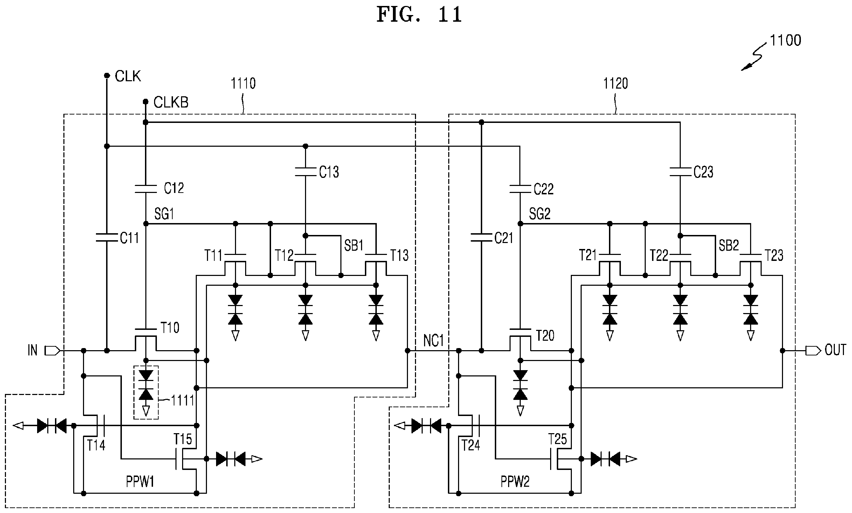

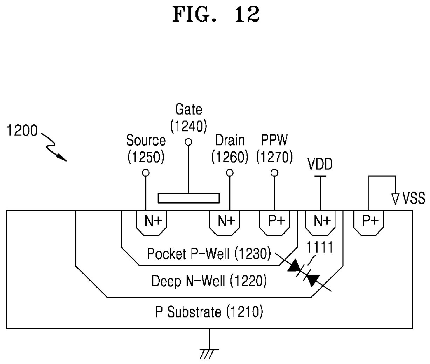

FIG. 11 is a circuit diagram of a voltage generation circuit 1100 according to an exemplary embodiment. The voltage generation circuit 1100 of FIG. 11 may generate a negative voltage by using transistors having a triple-well structure (e.g., T10 to T15). The transistor having a triple-well structure will be described in detail below with reference to FIG. 12.

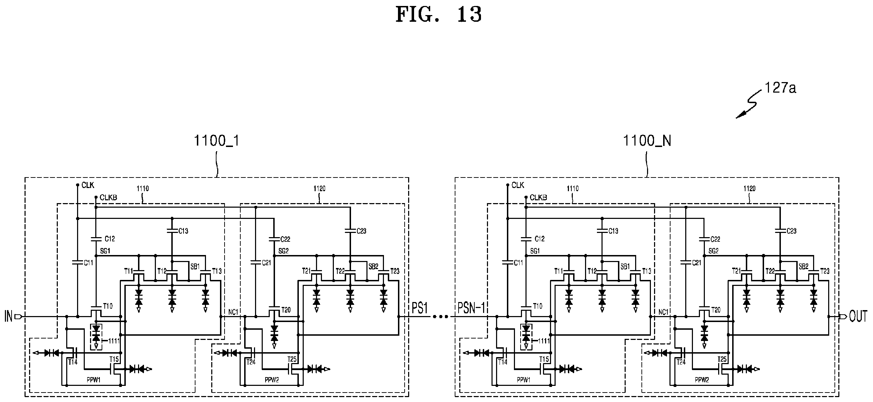

Referring to FIG. 11, the voltage generation circuit 1100 has a 2-stage charge pump structure including a first charge pump 1110 and a second charge pump 1120. The first and second charge pumps 1110 and 1120 may be connected in series to each other, and may have the same configuration. Although the voltage generation circuit 1100 includes two charge pumps in the current exemplary embodiment, the number of charge pumps may be variously changed. The voltage generation circuit 1100 may serve as a unit circuit of the voltage generation circuit 127a of FIG. 13 (discussed below) for generating a negative high voltage.

The first charge pump 1110 may include a charge transfer transistor T10, a first control transistor T11, a second control transistor T12 and a third control transistor T13, and a bias circuit including a first bias transistor T14 and a second bias transistor T15. The charge transfer transistor T10, the first to third control transistors T11 to T13, and the first and second bias transistors T14 and T15 are configured as triple-well N-type metal-oxide-semiconductor (MOS) transistors. The first charge pump 1110 further includes a first capacitor C11, a second capacitor C12, and a third capacitor C13. In some exemplary embodiments, the first capacitor C11 and the second capacitor C12 may be referred to as input capacitors. In some exemplary embodiments, the third capacitor may be referred to as a control capacitor.

The charge transfer transistor T10 is connected between an input terminal IN and a first connection node NC1. A source of the charge transfer transistor T10 is connected to the input terminal IN, and a drain thereof is connected to the first connection node NC1. The first connection node NC1 serves as an output terminal of the first charge pump 1110. A gate SG1 of the charge transfer transistor T10 is connected to an end of the second capacitor C12. The charge transfer transistor T10 serves as a switching transistor in a charge pump operation, and may have a charge transfer function.

A source of the first control transistor T11 is connected to the drain of the charge transfer transistor T10. An interconnected gate and drain of the first control transistor T11 are diode-connected to the gate SG1 of the charge transfer transistor T10. The first control transistor T11 may control a voltage level of the gate SG1 of the charge transfer transistor T10. The first control transistor T11 may control the voltage level of the gate SG1 of the charge transfer transistor T10 to be reduced by a threshold voltage Vth of the first control transistor T11 from a drain voltage of the charge transfer transistor T10.

A source of the second control transistor T12 is connected to the drain of the first control transistor T11 and the gate SG1 of the charge transfer transistor T10. An interconnected gate and drain of the second control transistor T12 are diode-connected to an end of the third capacitor C13. For convenience of explanation, nodes where the gate and drain of the second control transistor T12 are connected to the end of the third capacitor C13 are referred to as sub nodes SB1. In the above description, the input terminal IN may be referred to as a first node, the gate SG1 of the charge transfer transistor T10 may be referred to as a second node, the sub node SB1 may be referred to as a third node, and the first connection node NC1 may be referred to as a fourth node.

In operation of the first charge pump 1110, electrons may flow into the gate SG1 of the charge transfer transistor T10 through the first control transistor T11 serving as a diode. Due to the electrons flowing into the gate SG1 of the charge transfer transistor T10, the charge transfer transistor T10 which responds to a second clock signal CLKB may not be fully turned on. To offset the electrons flowing into the gate SG1 of the charge transfer transistor T10, the second control transistor T12 may provide a current to supply positive charges to the gate SG1 of the charge transfer transistor T10.

A source of the third control transistor T13 is connected to the drain of the second control transistor T12. A drain of the third control transistor T13 is connected to the drain of the charge transfer transistor T10. A gate of the third control transistor T13 is connected to the gate SG1 of the charge transfer transistor T10.

During operation of the first charge pump 1110, electrons may flow into the sub nodes SB1 through the second control transistor T12 serving as a diode. Due to the electrons flowing into the sub nodes SB1, the second control transistor T12 connected to a line of a first clock signal CLK may not sufficiently operate as a diode. To offset the electrons flowing into the sub nodes SB1, the third control transistor T13 may provide a current to supply positive charges to the sub nodes SB1.

The first to third control transistors T11 to T13 may serve as a controller for improving the charge transfer function of the charge transfer transistor T10.

The first capacitor C11 is connected between the line of the first clock signal CLK and the source of the charge transfer transistor T10. The first capacitor C11 may serve as a pump capacitor of the first charge pump 1110. The second capacitor C12 is connected between a line of the second clock signal CLKB and the gate SG1 of the charge transfer transistor T10. The second capacitor C12 may serve as a capacitor for controlling the gate SG1 of the charge transfer transistor T10. The third capacitor C13 is connected between the line of the first clock signal CLK and the sub nodes SB1 to which the second control transistor T12 is connected. The third capacitor C13 may serve as a capacitor for controlling the sub nodes SB1 to which the second control transistor T12 is connected.

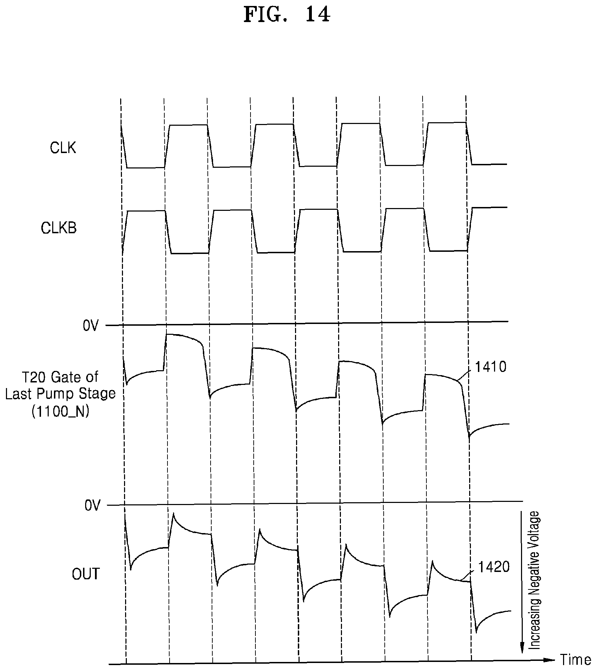

The first and second clock signals CLK and CLKB may toggle between a logic high level and a logic low level, and may have a same duty cycle but opposite logic levels (as shown, for example, in FIG. 14 discussed below). In other words, the first and second clock signals CLK and CLKB may have a 180 degree phase difference with a same duty cycle. Each of the first and second clock signals CLK and CLKB may have a logic high level at the level of a supply voltage VDD and have a logic low level at the level of a ground voltage VSS. The first and second clock signals CLK and CLKB may be provided by the control logic 124 of FIG. 2.

The first and second bias transistors T14 and T15 may be provided in such a manner that the first charge pump 1110 performs a negative charge pump operation without a body effect. To remove the body effect, the first and second bias transistors T14 and T15 operate to bias a potential of a pocket P-well PPW1 of the triple-well N-type MOS transistors. In addition, the first and second bias transistors T14 and T15 operate not to operate diodes 1111 and bipolar junction transistors parasitically generated in a substrate having the triple-well N-type MOS transistors.

Sources of the first and second bias transistors T14 and T15 are connected to each other, and connected to a terminal of the pocket P-well PPW1 where the charge transfer transistor T10, the first to third control transistors T11 to T13, and the first and second bias transistors T14 and T15 are provided. A gate of the first bias transistor T14 is connected to the drain of the charge transfer transistor T10, and a gate of the second bias transistor T15 is connected to the source of the charge transfer transistor T10. A drain of the first bias transistor T14 is connected to the source of the charge transfer transistor T10, and a drain of the second bias transistor T15 is connected to the drain of the charge transfer transistor T10.

The first and second bias transistors T14 and T15 operate to maintain the potential of the pocket P-well PPW1 of the triple-well N-type MOS transistors (e.g., T10 to T15) at a lower voltage between source and drain voltages of the charge transfer transistor T10. When the source voltage of the charge transfer transistor T10 is higher than the drain voltage thereof, the second bias transistor T15 is turned on and the drain voltage of the charge transfer transistor T10 serves as a bias voltage of the pocket P-well PPW1 where the charge transfer transistor T10, the first to third control transistors T11 to T13, and the first and second bias transistors T14 and T15 are provided. When the source voltage of the charge transfer transistor T10 is lower than the drain voltage thereof, the first bias transistor T14 is turned on and the source voltage of the charge transfer transistor T10 serves as a bias voltage of the pocket P-well PPW1 where the charge transfer transistor T10, the first to third control transistors T11 to T13, and the first and second bias transistors T14 and T15 are provided.

The second charge pump 1120 may have the same configuration as the first charge pump 1110, and may be connected in series to the first charge pump 1110.

The second charge pump 1120 includes a charge transfer transistor T20, a first control transistor T21, a second control transistor T22, and a third control transistor T23, and a bias circuit including a first bias transistor T24 and a second bias transistor T25. The second charge pump 1120 further includes a first capacitor C21, a second capacitor C22 and a third capacitor C23. The charge transfer transistor T20, the first to third control transistors T21 to T23, and the first and second bias transistors T24 and T25 are configured as triple-well N-type MOS transistors, and a potential of a pocket P-well PPW2 where the triple-well N-type MOS transistors (e.g., T20 to T25) are provided is biased by the first and second bias transistors T24 and T25.

The charge transfer transistor T20 is connected between the output terminal of the first charge pump 1110, i.e., the first connection node NC1, and an output terminal OUT of the voltage generation circuit 1100. Since the first connection node NC1 is a node to which the drain of the charge transfer transistor T10 of the first charge pump 1110 is connected, a source of the charge transfer transistor T20 is connected to the drain of the charge transfer transistor T10. A gate SG2 of the charge transfer transistor T20 is connected to an end of the second capacitor C22. A drain of the charge transfer transistor T20 is connected to the output terminal OUT of the voltage generation circuit 1100.

A source of the first control transistor T21 is connected to the drain of the charge transfer transistor T20. An interconnected gate and drain of the first control transistor T21 are diode-connected to the gate SG2 of the charge transfer transistor T20. A source of the second control transistor T22 is connected to the drain of the first control transistor T21 and the gate SG2 of the charge transfer transistor T20. An interconnected gate and drain of the second control transistor T22 are diode-connected to an end of the third capacitor C23. A source of the third control transistor T23 is connected to the drain of the second control transistor T22. A drain of the third control transistor T23 is connected to the drain of the charge transfer transistor T20. A gate of the third control transistor T23 is connected to the gate SG2 of the charge transfer transistor T20.

The first capacitor C21 is connected between the line of the second clock signal CLKB and the source of the charge transfer transistor T20. The second capacitor C22 is connected between the line of the first clock signal CLK and the gate SG2 of the charge transfer transistor T20. The third capacitor C23 is connected between the line of the second clock signal CLKB and the gate of the second control transistor T22.

Sources of the first and second bias transistors T24 and T25 are connected to each other, and connected to a terminal of the pocket P-well PPW2 where the charge transfer transistor T20, the first to third control transistors T21 to T23, and the first and second bias transistors T24 and T25 are provided.

A gate of the first bias transistor T24 is connected to the drain of the charge transfer transistor T20, and a gate of the second bias transistor T25 is connected to the source of the charge transfer transistor T20. A drain of the first bias transistor T24 is connected to the source of the charge transfer transistor T20, and a drain of the second bias transistor T25 is connected to the drain of the charge transfer transistor T20. The first and second bias transistors T24 and T25 operate to maintain the potential of the pocket P-well PPW2 of the triple-well N-type MOS transistors (e.g., T20 to T25) at a lower voltage between source and drain voltages of the charge transfer transistor T20.

To generate and output a negative voltage from the output terminal OUT, the ground voltage VSS may be applied to the input terminal IN of the voltage generation circuit 1100 including the first and second charge pumps 1110 and 1120. The first and second clock signals CLK and CLKB are complementary to each other and thus have a same duty cycle but have opposite logic levels.

It is assumed that the first clock signal CLK initially has a logic low level and the second clock signal CLKB initially has a logic high level with a same duty cycle as the duty cycle of the first clock signal CLK. In the first charge pump 1110, the charge transfer transistor T10 is turned on in response to the second clock signal CLKB corresponding to the level of the supply voltage VDD, and a current flows in a direction from the drain to the source of the charge transfer transistor T10 due to charge sharing through the charge transfer transistor T10 between the first capacitor C21 of the second charge pump 1120 connected to the supply voltage VDD and the first capacitor C11 of the first charge pump 1110 connected to the ground voltage VSS. As such, the drain voltage of the charge transfer transistor T10 may have a first voltage level lower than the level of the supply voltage VDD.

Thereafter, the first clock signal CLK transitions to a logic high level, and the second clock signal CLKB transitions to a logic low level. In the first charge pump 1110, the charge transfer transistor T10 of the first charge pump 1110 may be turned off in response to the second clock signal CLKB having a logic low level, and the second control transistor T12 may supply positive charges to the gate SG1 of the charge transfer transistor T10 and the third control transistor T13 may supply positive charges to the sub nodes SB1 in response to the first clock signal CLK having a logic high level.

In the second charge pump 1120, the charge transfer transistor T20 is turned on in response to the first clock signal CLK having a logic high level. The source of the charge transfer transistor T20 may be connected to the first capacitor C21 coupled to the line of the ground voltage VSS, and the drain of the charge transfer transistor T20 may be connected to a capacitor connected to the output terminal OUT. For example, when the voltage generation circuit 1100 is configured as one of first to N-th pump stages 1100_1, ... , 1100_N of FIG. 13, the drain of the charge transfer transistor T20 may be connected to the first capacitor C11 of a next pump stage. In this case, charge sharing occurs through the charge transfer transistor T20 between the first capacitor C21 and the first capacitor C11 of the next pump stage. As such, the drain of the charge transfer transistor T20 may have a second voltage level lower than the level of the drain voltage of the charge transfer transistor T10 of the first charge pump 1110, i.e., the first voltage level.

The above-described voltage generation circuit 1100 may be applied to a voltage generation circuit 127a of FIG. 13 (discussed below), and thus charge sharing through the first to third capacitors C11 to C13, and C21 to C23 and the charge transfer transistors T10 and T20, which are coupled to the first and second clock signals CLK and CLKB, may be repeatedly performed by the first to N-th pump stages 1100_1, ... , 1100_N. As such, the output terminal OUT of the voltage generation circuit 1100 of any one of the first to N-th pump stages 1100_1, ... , 1100_N may output a negative voltage.

FIG. 12 is a cross-sectional diagram of a triple-well N-type MOS transistor 1200 applicable to FIG. 11.

Referring to FIG. 12, the triple-well N-type MOS transistor 1200 may include a P-type substrate 1210, a deep N-well 1220, a pocket P-well 1230, a gate 1240, a source 1250, and a drain 1260. The P-type substrate 1210 is biased to the ground voltage VSS, and the deep N-well 1220 is biased to the supply voltage VDD. According to some exemplary embodiments, like the P-type substrate 1210, the deep N-well 1220 may be biased to the ground voltage VSS. The pocket P-well 1230 is biased due to a voltage applied to a pocket P-well terminal PPW 1270.

For example, it is assumed that the triple-well N-type MOS transistor 1200 is the charge transfer transistor T10 (see FIG. 11). The gate 1240 may be connected to an end of the second capacitor C12, the source 1250 may be connected to the input terminal IN of the first charge pump 1110, and the drain 1260 may be connected to the output terminal of the first charge pump 1110, i.e., the first connection node NC1. The pocket P-well terminal PPW 1270 may be biased through the first or second bias transistor T14 or T15 to a lower voltage, e.g., a negative voltage, between the source and drain voltages of the charge transfer transistor T10. As such, the parasitic diodes 1111 are reverse-biased in the structure of the triple-well N-type MOS transistor 1200.

FIG. 13 is a circuit diagram of a voltage generation circuit 127a according to an exemplary embodiment.

Referring to FIG. 13, the voltage generation circuit 127a includes first to N-th pump stages 1100_1, ... , 1100_N (N is a natural number equal to or greater than 2). Each of the first to N-th pump stages 1100_1, ... , 1100_N may be configured as the voltage generation circuit 1100 including the first and second charge pumps 1110 and 1120 described above in relation to FIG. 11. The voltage generation circuit 127a has a structure in which N voltage generation circuits 1100 are connected in series to each other. In other words, the voltage generation circuit 1100 may form a unit circuit of the voltage generation circuit 127a.

The voltage generation circuit 127a may output a negative high voltage from the output terminal OUT by down-pumping the level of a voltage applied to the input terminal IN. For example, the ground voltage VSS may be applied to the input terminal IN.

In the first pump stage 1100_1, the ground voltage VSS may be applied to the source of the charge transfer transistor T10 (see FIG. 11) connected to the input terminal IN, and a first negative voltage may be output from an output node PS1 of the first pump stage 1100_1 due to the charge transfer transistor T10 (see FIG. 11) which responds to the second clock signal CLKB, and the charge transfer transistor T20 (see FIG. 11) which responds to the first clock signal CLK.

The output node PS1 of the first pump stage 1100_1, which outputs the first negative voltage, may be connected to an input terminal of a next pump stage, and an output node of the next pump stage may output a second negative voltage lower than the first negative voltage. The above-described operation may be sequentially performed by multiple pump stages, and thus the (N-1)-th pump stage 1100_N-1 may output a third negative voltage lower than the second negative voltage.

An input terminal of the N-th pump stage 1100_N, which is the last pump stage of the voltage generation circuit 127a, may be connected to an output node PSN-1 of the (N-1)-th pump stage 1100_N-1, which outputs the third negative voltage. The N-th pump stage 1100 N may output a fourth negative voltage lower than the third negative voltage from an output node thereof due to the charge transfer transistor T10 (see FIG. 11) which responds to the second clock signal CLKB, and the charge transfer transistor T20 (see FIG. 11) which responds to the first clock signal CLK. An output node of the charge transfer transistor T20 (see FIG. 11) may be connected to the output terminal OUT of the voltage generation circuit 127a.

The voltage generation circuit 127a may receive the ground voltage VSS through the input terminal IN and generate and output the fourth negative voltage much lower than the ground voltage VSS, from the output terminal OUT. The fourth negative voltage may be set as a target voltage of the voltage generation circuit 127a. For example, the target voltage of the voltage generation circuit 127a may be set to a negative high voltage provided to a selected word line in an erase operation of a NOR flash memory device.

FIG. 14 is a timing diagram based on operation of the voltage generation circuit 1100 of FIG. 11 or the voltage generation circuit 127a of FIG. 13.

Referring to FIGS. 11, 13, and 14, operation of the voltage generation circuit 127a is controlled based on the first and second clock signals CLK and CLKB. Each of the first to N-th pump stages 1100_1, ... , 1100_N of the voltage generation circuit 127a may perform a charge pump operation based on a turned-on or turned-off state of the charge transfer transistors T10 and T20 which respond to the first and second clock signals CLK and CLKB. For example, in the N-th pump stage 1100_N, which is the last pump stage of the voltage generation circuit 127a, a voltage pulse 1410 coupled to the first clock signal CLK may be applied to the gate of the charge transfer transistor T20 through the second capacitor C22.

Whenever the voltage pulse 1410 coupled to the first clock signal CLK having a logic high level is applied to the gate of the charge transfer transistor T20 of the N-th pump stage 1100_N, the charge transfer transistor T20 is turned on, charge sharing occurs through the charge transfer transistor T20, and a drain voltage of the charge transfer transistor T20 becomes lower than a source voltage thereof. Due to toggling of the first and second clock signals CLK and CLKB, the drain voltage of the charge transfer transistor T20 may become much lower than the source voltage thereof. As such, the output terminal OUT of the voltage generation circuit 127a, which is connected to the drain of the charge transfer transistor T20, may output a negative high voltage pulse 1420.

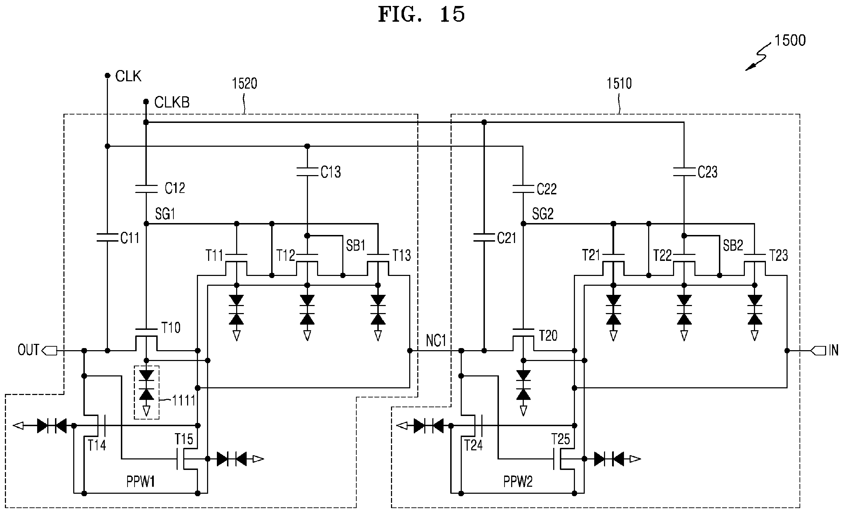

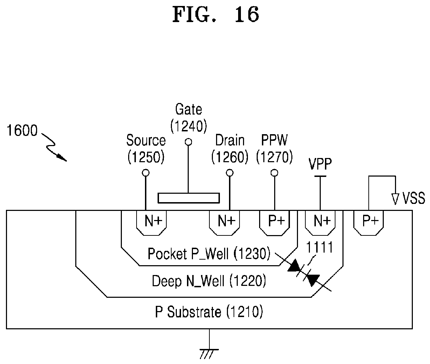

FIG. 15 is a circuit diagram of a voltage generation circuit 1500 according to an exemplary embodiment. The voltage generation circuit 1500 of FIG. 15 may generate a positive voltage by using transistors having a triple-well structure. The transistor having a triple-well structure will be described in detail below with reference to FIG. 16.

Referring to FIG. 15, the voltage generation circuit 1500 may serve as a unit circuit of the voltage generation circuit 127b of FIG. 15 (discussed below) for generating a positive high voltage. The configuration of the voltage generation circuit 1500 is the same as that of the voltage generation circuit 1100 of FIG. 11 except that the input terminal IN and the output terminal OUT are switched. The following description focuses on the differences from FIG. 11.

In a first charge pump 1510, the charge transfer transistor T20 may transfer charges of the input terminal IN to the first connection node NC1. The supply voltage VDD may be applied to the input terminal IN. To improve charge transfer efficiency of the charge transfer transistor T20, the first and second bias transistors T24 and T25 operate to maintain a potential of the pocket P-well PPW2 of the triple-well N-type MOS transistors (e.g., T20 to T25) at a lower voltage between source and drain voltages of the charge transfer transistor T20. Due to charge sharing through the first to third capacitors C21 to C23 and the charge transfer transistor T20, which respond to the first and second clock signals CLK and CLKB, the first connection node NC1 may have a voltage level higher than the level of the supply voltage VDD.

A second charge pump 1520 may be connected in series to the first charge pump 1510. In the second charge pump 1520, the charge transfer transistor T10 may transfer charges of the first connection node NC1 to the output terminal OUT. To improve charge transfer efficiency of the charge transfer transistor T10, the first and second bias transistors T14 and T15 operate to maintain a potential of the pocket P-well PPW1 of the triple-well N-type MOS transistors (e.g., T10 to T15) at a lower voltage between source and drain voltages of the charge transfer transistor T10. Due to charge sharing through the first to third capacitors C11 to C13 and the charge transfer transistor T10, which respond to the first and second clock signals CLK and CLKB, the output terminal OUT may have a voltage level higher than the voltage level of the first connection node NC1. As such, the voltage generation circuit 1500 may output a voltage boosted from the supply voltage VDD of the input terminal IN, from the output terminal OUT in response to the first and second clock signals CLK and CLKB.

FIG. 16 is a cross-sectional diagram of a triple-well N-type MOS transistor 1600 applicable to FIG. 15.

Referring to FIG. 16, the structure of the triple-well N-type MOS transistor 1600 is the same as that of the triple-well N-type MOS transistor 1200 of FIG. 12 except that the deep N-well 1220 is biased to a boosted voltage VPP. The boosted voltage VPP has a voltage level higher than the level of the supply voltage VDD. As such, the diodes 1111 and bipolar junction transistors parasitically generated in a substrate having the triple-well N-type MOS transistors are reverse-biased, thereby preventing an abnormal phenomenon, e.g., latch-up.

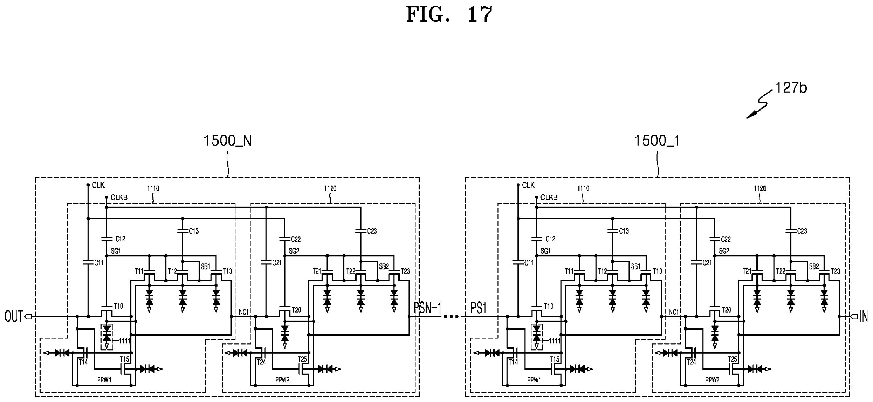

FIG. 17 is a circuit diagram of a voltage generation circuit 127b according to an exemplary embodiment.

Referring to FIG. 17, the voltage generation circuit 127b includes first to N-th pump stages 1500_1, ... , 1500_N (N is a natural number equal to or greater than 2). Each of the first to N-th pump stages 1500_1, ... , 1500_N may be configured as the voltage generation circuit 1500 including the first and second charge pumps 1510 and 1520 described above in relation to FIG. 15. The voltage generation circuit 127b has a structure in which N voltage generation circuits 1500 are connected in series to each other. In other words, the voltage generation circuit 1500 may form a unit circuit of the voltage generation circuit 127b.

The voltage generation circuit 127b may output a positive high voltage from the output terminal OUT by up-pumping the level of a voltage applied to the input terminal IN. For example, the supply voltage VDD may be applied to the input terminal IN.

In the first pump stage 1500_1, the supply voltage VDD may be applied to the source of the charge transfer transistor T20 connected to the input terminal IN, and a first positive voltage higher than the supply voltage VDD may be output from an output node PS1 of the first pump stage 1500_1 due to the charge transfer transistor T20 which responds to the first clock signal CLK, and the charge transfer transistor T10 which responds to the second clock signal CLKB.

The output node PS1 of the first pump stage 1500_1, which outputs the first positive voltage, may be connected to an input terminal of a next pump stage, and an output node of the next pump stage may output a second positive voltage higher than the first positive voltage. The above-described operation may be sequentially performed by multiple pump stages, and thus the (N-1)-th pump stage 1500_N-1 may output a third positive voltage higher than the second positive voltage.

An input terminal of the N-th pump stage 1500_N, which is the last pump stage of the voltage generation circuit 127b, may be connected to an output node PSN-1 of the (N-1)-th pump stage 1500_N-1, which outputs the third positive voltage. The N-th pump stage 1500 N may output a fourth positive voltage higher than the third positive voltage from the output terminal OUT of the voltage generation circuit 127b due to the charge transfer transistor T20 which responds to the first clock signal CLK, and the charge transfer transistor T10 which responds to the second clock signal CLKB. As such, The voltage generation circuit 127b may receive the supply voltage VDD through the input terminal IN and generate and output the fourth positive voltage much higher than the supply voltage VDD, from the output terminal OUT. The fourth positive voltage may be set as a target voltage of the voltage generation circuit 127b.

For example, the target voltage of the voltage generation circuit 127b may be set to a program voltage corresponding to a positive high voltage provided to a selected word line in a program operation of a NAND flash memory device, or to an erase voltage corresponding to a positive high voltage provided to a bulk of a selected memory block in an erase operation of the NAND flash memory device. The target voltage of the voltage generation circuit 127b may be set to a program voltage corresponding to a positive high voltage provided to a selected word line in a program operation of a NOR flash memory device, or to an erase voltage corresponding to a positive high voltage provided to a bulk of a selected memory block in an erase operation of the NOR flash memory device.

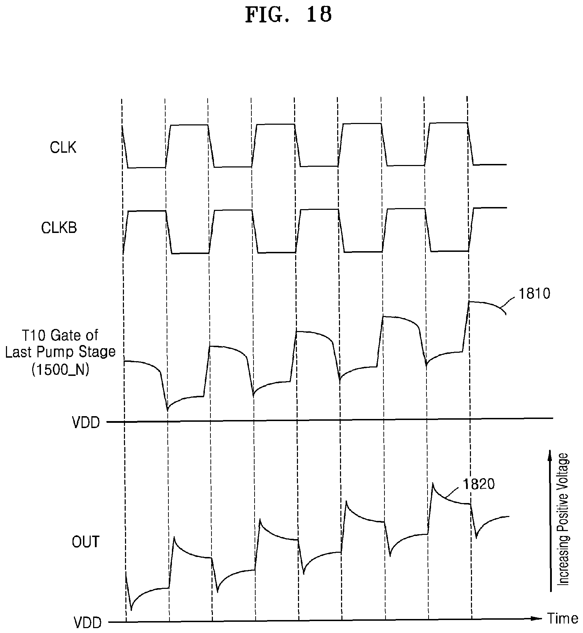

FIG. 18 is a timing diagram based on operation of the voltage generation circuit 1500 of FIG. 15 or the voltage generation circuit 127b of FIG. 17.

Referring to FIGS. 15, 17, and 18, operation of the voltage generation circuit 127b is controlled based on the first and second clock signals CLK and CLKB. Each of the first and second clock signals CLK and CLKB may toggle between a logic high level and a logic low level, and may have a logic high level at the level of the supply voltage VDD and have a logic low level at the level of the ground voltage VSS.

Each of the first to N-th pump stages 1500_1, ... , 1500_N of the voltage generation circuit 127b may perform a charge pump operation based on a turned-on or turned-off state of the charge transfer transistors T20 and T10 which respond to the first and second clock signals CLK and CLKB. In the N-th pump stage 1500_N, which is the last pump stage of the voltage generation circuit 127b, a voltage pulse 1810 coupled to the second clock signal CLKB may be applied to the gate of the charge transfer transistor T10 through the second capacitor C12.

Whenever the voltage pulse 1810 coupled to the second clock signal CLKB having a logic high level is applied to the gate of the charge transfer transistor T10 of the N-th pump stage 1500_N, charges may be transferred to the output terminal OUT through the charge transfer transistor T10, and charge boosting may occur in the output terminal OUT due to the first to third capacitors C11 to C13 and the first to third control transistors T11 to T13, which respond to the first and second clock signals CLK and CLKB. As such, the output terminal OUT of the voltage generation circuit 127b may output a positive high voltage pulse 1820.

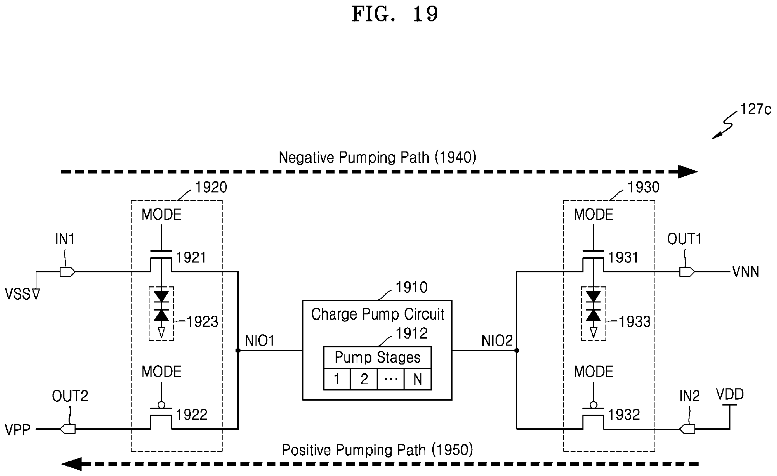

FIG. 19 is a circuit diagram of a voltage generation circuit 127c according to an exemplary embodiment.

Referring to FIG. 19, the voltage generation circuit 127c may selectively generate a positive or negative high voltage in response to a mode signal MODE. In other words, the voltage generation circuit 127c may be bi-directional. The voltage generation circuit 127c includes a charge pump circuit 1910 and a first selector 1920 and a second selector 1930.

The charge pump circuit 1910 is connected between a first input/output node NIO1 and a second input/output node NIO2. The charge pump circuit 1910 may include a plurality of pump stages 1912 connected in series between the first and second input/output nodes NIO1 and NIO2. For example, the configuration of the charge pump circuit 1910 may be the same as that of the voltage generation circuit 127a of FIG. 13 or the voltage generation circuit 127b of FIG. 17. The input terminal IN of the voltage generation circuit 127a of FIG. 13 or the output terminal OUT of the voltage generation circuit 127b of FIG. 17 may be connected to the first input/output node NIO1. The output terminal OUT of the voltage generation circuit 127a of FIG. 13 or the input terminal IN of the voltage generation circuit 127b of FIG. 17 may be connected to the second input/output node NIO2.

The first selector 1920 may include a first transistor 1921 and a second selection transistor 1922 which respond to the mode signal MODE. The first selection transistor 1921 may be configured as the triple-well N-type MOS transistor (see FIG. 12 or 16) connected between a first input terminal IN1 and the first input/output node NIO1. A source of the first selection transistor 1921 may be connected to the first input terminal IN1, a drain thereof may be connected to the first input/output node NIO1, and a gate thereof may be connected to the mode signal MODE.

The second selection transistor 1922 may be configured as a P-type MOS transistor connected between the first input/output node NIO1 and a second output terminal OUT2. A source of the second selection transistor 1922 may be connected to the first input/output node NIO1, a drain thereof may be connected to the second output terminal OUT2, and a gate thereof may be connected to the mode signal MODE. The second selection transistor 1922 may output a voltage of the first input/output node NIO1 of the charge pump circuit 1910 to the second output terminal OUT2 in response to the mode signal MODE having a logic low level. In this case, the charge pump circuit 1910 may operate like the voltage generation circuit 127b (see FIG. 17) for generating a positive high voltage and outputting the positive high voltage to the first input/output node NIO1.

The second selector 1930 may include a third selection transistor 1931 and a fourth selection transistor 1932 which respond to the mode signal MODE. The third selection transistor 1931 may be configured as the triple-well N-type MOS transistor (see FIG. 12 or 16) connected between the second input/output node NIO2 and a first output terminal OUT1. A source of the third selection transistor 1931 may be connected to the second input/output node NIO2, a drain thereof may be connected to the first output terminal OUT1, and a gate thereof may be connected to the mode signal MODE.

The fourth selection transistor 1932 may be configured as a P-type MOS transistor connected between a second input terminal IN2 and the second input/output node NIO2. A source of the fourth selection transistor 1932 may be connected to the second input terminal IN2, a drain thereof may be connected to the second input/output node NIO2, and a gate thereof may be connected to the mode signal MODE. The fourth selection transistor 1932 may transfer charges of the second input terminal IN2 to the second input/output node NIO2 of the charge pump circuit 1910 in response to the mode signal MODE having a logic low level. In this case, the charge pump circuit 1910 may operate like the voltage generation circuit 127b (see FIG. 17) for generating a positive high voltage and outputting the positive high voltage to the first input/output node NIO1.

When the mode signal MODE has a logic high level, the voltage generation circuit 127c may generate a negative pump path 1940 through the first input terminal IN1, the first selection transistor 1921, the first input/output node NIO1, the charge pump circuit 1910, the second input/output node NIO2, the third selection transistor 1931, and the first output terminal OUT1. When the ground voltage VSS is applied to the first input terminal IN1, the voltage generation circuit 127c may generate a negative high voltage VNN through the negative pump path 1940.

When the mode signal MODE has a logic low level, the voltage generation circuit 127c may generate a positive pump path 1950 through the second input terminal IN2, the fourth selection transistor 1932, the second input/output node NIO2, the charge pump circuit 1910, the first input/output node NIO1, the second selection transistor 1922, and the second output terminal OUT2. When the supply voltage VDD is applied to the second input terminal IN2, the voltage generation circuit 127c may generate a positive high voltage VPP through the positive pump path 1950.

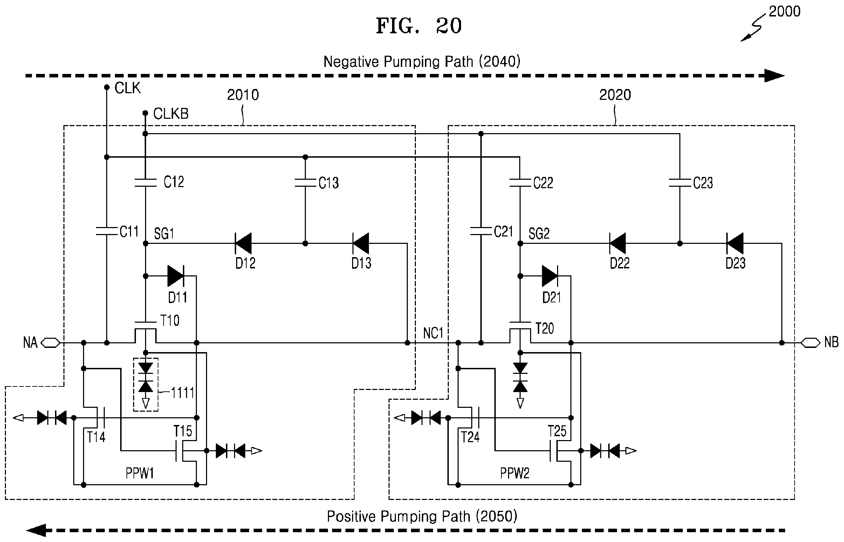

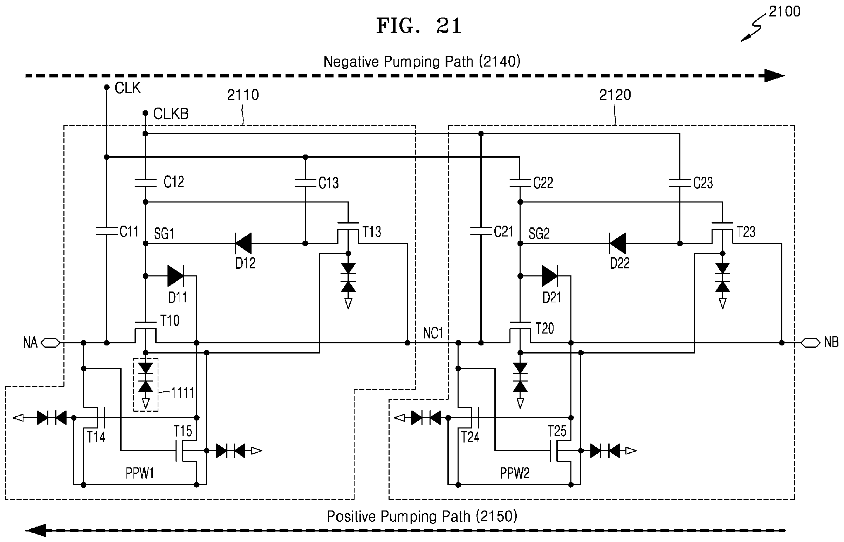

FIGS. 20 and 21 are circuit diagrams for describing pump stages 2000 and 2100, respectively, in the charge pump circuit 1910 of FIG. 19. Each of the pump stages 2000 and 2100 of FIGS. 20 and 21 is a unit pump stage included in the pump stages 1912 of FIG. 19, and may correspond to one of the first to N-th pump stages 1100_1, ... , 1100_N of FIG. 13 or the first to N-th pump stages 1500_1, ... , 1500_N of FIG. 17. For convenience of explanation, it is assumed that each of the pump stages 2000 and 2100 of FIGS. 20 and 21 corresponds to the first pump stage 1100_1 of FIG. 13. Since the first pump stage 1100_1 of FIG. 13 is configured as the voltage generation circuit 1100 of FIG. 11, the following description focuses on the differences from FIG. 11.

The pump stage 2000 of FIG. 20 differs from the voltage generation circuit 1100 of FIG. 11 in that a first charge pump 2010 includes a first diode D11, a second diode D12, and a third diode D13, and a second charge pump 2020 includes a first diode D21, a second diode D22 and a third diode D23. The first to third diodes D11 to D13, and D21 to D23 are used instead of the first to third control transistors T11 to T13, and T21 to T23 in the first and second charge pumps 1110 and 1120 of FIG. 11.

In the first charge pump 2010, the first diode D11 is connected to the gate and drain of the charge transfer transistor T10. An anode of the first diode D11 is connected to the gate of the charge transfer transistor T10, and a cathode thereof is connected to the drain of the charge transfer transistor T10. The second and third diodes D12 and D13 are connected in series to each other, an anode of the third diode D13 is connected to the drain of the charge transfer transistor T10, and a cathode of the second diode D12 is connected to the gate of the charge transfer transistor T10. An end of the third capacitor C13 is connected to a connection node between the second and third diodes D12 and D13, and a line of the first clock signal CLK is connected to the other end of the third capacitor C13.

In the second charge pump 2020, the first diode D21 is connected to the gate and drain of the charge transfer transistor T20. An anode of the first diode D21 is connected to the gate of the charge transfer transistor T20, and a cathode thereof is connected to the drain of the charge transfer transistor T20. The second and third diodes D22 and D23 are connected in series, an anode of the third diode D23 is connected to the drain of the charge transfer transistor T20, a cathode of the second diode D22 is connected to the gate of the charge transfer transistor T20. An end of the third capacitor C23 is connected to a connection node between the second and third diodes D22 and D23, and the line of the second clock signal CLKB is connected to the other end of the third capacitor C23.

The pump stage 2000 may generate a negative pump path 2040 through a first connection node NA to which the charge transfer transistor T10 is connected, the charge transfer transistors T10 and T20, and a second connection node NB to which the charge transfer transistor T20 is connected. In the pump stage 2000, a voltage level of the second connection node NB may be output to be lower than a voltage level of the first connection node NA through the negative pump path 2040.

The pump stage 2000 may generate a positive pump path 2050 through the second connection node NB, the charge transfer transistors T20 and T10, and the first connection node NA. In the pump stage 2000, a voltage level of the first connection node NA may be output to be higher than a voltage level of the second connection node NB through the positive pump path 2050.

The pump stage 2100 of FIG. 21 differs from the pump stage 2000 of FIG. 20 in that the third control transistors T13 are T23 are used instead of the third diodes D13 and D23, respectively.

In a first charge pump 2110, a source of the third control transistor T13 is connected through the third capacitor C13 to the line of the first clock signal CLK, a drain thereof is connected to the drain of the charge transfer transistor T10, and a gate thereof is connected to the gate SG1 of the charge transfer transistor T10.

In a second charge pump 2120, a source of the third control transistor T23 is connected through the third capacitor C23 to the line of the second clock signal CLKB, a drain thereof is connected to the drain of the charge transfer transistor T20, and a gate thereof is connected to the gate SG2 of the charge transfer transistor T20.

The pump stage 2100 may generate a negative pump path 2140 through a first connection node NA to which the charge transfer transistor T10 is connected, the charge transfer transistors T10 and T20, and a second connection node NB to which the charge transfer transistor T20 is connected, and thus a voltage level of the second connection node NB may be output to be lower than a voltage level of the first connection node NA. In addition, the pump stage 2100 may generate a positive pump path 2150 through the second connection node NB, the charge transfer transistors T20 and T10, and the first connection node NA, and thus a voltage level of the first connection node NA may be output to be higher than a voltage level of the second connection node NB.

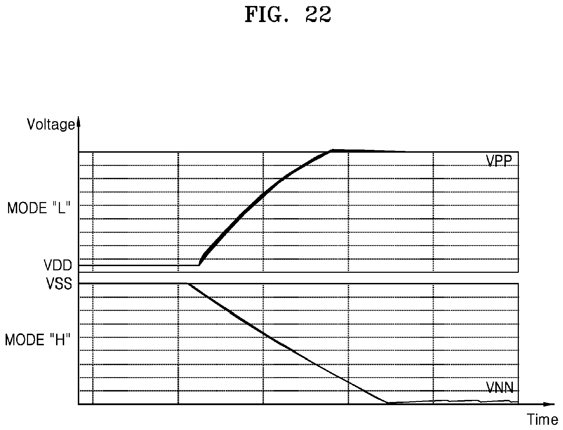

FIG. 22 is a waveform diagram for describing operation of the voltage generation circuit 127c of FIG. 19.

Referring to FIGS. 19 and 22, when the mode signal MODE has a logic high level, the voltage generation circuit 127c may generate the negative high voltage VNN by performing a negative charge pump operation based on the ground voltage VSS applied to the first input terminal IN1. When the mode signal MODE has a logic low level, the voltage generation circuit 127c may generate the positive high voltage VPP by performing a positive charge pump operation based on the supply voltage VDD applied to the second input terminal IN2.

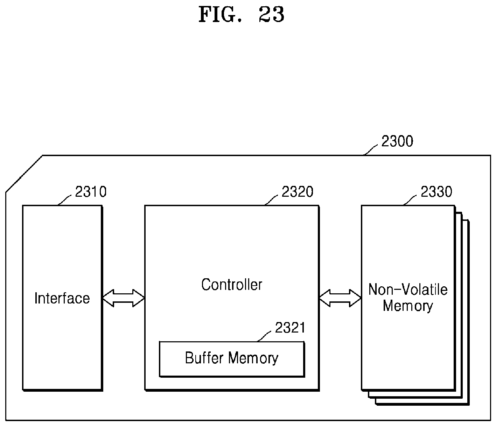

FIG. 23 is a block diagram of a memory card 2300 having a voltage generation circuit according to embodiments of the inventive concept.

The memory card 2300 of FIG. 23 may be a smart card, multimedia card (MMC), secure digital (SD) card, identification (ID) card, universal serial bus (USB) card, or the like. The memory card 2300 includes an interface 2310 interfacing with an external device, a controller 2320 for controlling operation of the memory card 2300 and having a buffer memory 2321, and at least one non-volatile memory device 2330. The non-volatile memory device 2330 of the memory card 2300 may be implemented using the exemplary embodiments described above in relation to FIGS. 1 to 22. The non-volatile memory device 2330 may include the voltage generation circuit for generating positive and/or negative high voltages used for program and erase operations.

While the inventive concept has been particularly shown and described with reference to various exemplary embodiments thereof, it will be understood that various changes in form and details may be made therein without departing from the scope of the following claims.

## Claims

1. A voltage generation circuit comprising:
a plurality of charge pumps (1110, 1120; 1520, 1510) connected in series, each of the plurality of charge pumps (1110, 1120; 1520, 1510) comprising:
a charge transfer transistor (T10, T20) having a drain, a source that receives a first clock , and a gate that is connected to a first node (SG1, SG2) and that receives a second clock opposite to the first clock;
a controller comprising a control transistor (T12, T22) having a source connected to the first node (SG1, SG2), a gate coupled to the first clock , and a drain connected to the gate of the control transistor (T12, T22); and
a bias circuit (T14, T15, T24, T25) configured to bias the charge transfer transistor (T10, T20).

2. The voltage generation circuit according to claim 1, wherein the charge transfer transistor (T10, T20) and the controller are provided on a pocket P-well(1230), and
the bias circuit (T14, T15, T24, T25) biases the pocket P-well (1230) to a lower voltage between a source voltage and a drain voltage of the charge transfer transistor (T10, T20).

3. The voltage generation circuit according to claim 1 or 2, wherein the charge transfer transistor (T10, T20) is configured as a triple-well N-type transistor (1200).

4. The voltage generation circuit according to claim 2, wherein the charge transfer transistor (T10, T20) is configured as a triple-well N-type transistor (1200) provided on the pocket P-well in a deep N-well (1220) provided in a P-type substrate (1210).

5. The voltage generation circuit according to any one of claims 1 to 4, wherein the controller comprises a plurality of triple-well N-type transistors (T11, T12, T13).

6. The voltage generation circuit according to any one of claims 1 to 5, wherein the plurality of charge pumps (1110, 1120; 1520, 1510) operate to produce an output voltage from an input voltage using only the first clock and the second clock.

7. A voltage generation circuit comprising:
a plurality of charge pumps (1110, 1120; 1520, 1510; 2010, 2020; 2110, 2120) connected in series, each of the plurality of charge pumps (1110, 1120; 1520, 1510; 2010, 2020; 2110, 2120) comprising:
a charge transfer transistor (T10, T20) having a drain, a source that receives a first clock through a first capacitor (C11, C21), and a gate that is connected to a first node (SG1, SG2) and that receives a second clock through a second capacitor (C12, C22), the second clock having a logic level opposite to a logic level of the first clock;
a controller connected to the first node (SG1, SG2), the controller receiving the first clock through a third capacitor (C13, C23) that is different from the first capacitor (C11, C21) and the second capacitor (C12, C22), wherein the controller is configured to offset electrons flowing into the gate of the charge transfer transistor; and
a bias circuit configured to bias the charge transfer transistor (T10, T20).

8. The voltage generation circuit according to claim 7, wherein the controller comprises:
a first transistor (T11, T21) having a source connected to the drain of the charge transfer transistor (T10, T20), a gate connected to the first node (SG1, SG2), and a drain connected to the gate of the first transistor (T11, T21);
a second transistor (T12, T22) having a source connected to a drain of the first transistor (T11, T21), a gate that receives the first clock through the third capacitor (C13, C23), and a drain connected to the gate of the second transistor (T12, T22); and
a third transistor (T13, T23) having a source connected to the drain of the second transistor (T12, T22), a gate connected to the first node (SG1, SG2), and a drain connected to the drain of the charge transfer transistor (T10, T20).

9. The voltage generation circuit according to claim 7, wherein the controller comprises:
a first diode (D11, D21) connected between the first node (SG1, SG2) and the drain of the charge transfer transistor (T10, T20);
a second diode (D12, D22) connected between the first node (SG1, SG2) and the third capacitor (C13, C23); and
a third diode (D13, D23) connected between the third capacitor (C13, C23) and the drain of the charge transfer transistor (T10, T20).

10. The voltage generation circuit according to claim 7, wherein the controller comprises:
a first diode (D11, D21) connected between the first node (SG1, SG2) and the drain of the charge transfer transistor (T10, T20);
a second diode (D12, D22) connected between the first node (D11, D21) and the third capacitor (C13, C23); and
a transistor (T13, T23) having a source connected to the third capacitor (D13, C23), a gate connected to the first node (SG1, SG2), and a drain connected to the drain of the charge transfer transistor (T10, T20).

11. The voltage generation circuit according to claim 8, wherein the charge transfer transistor (T10, T20) and the first through third transistors (T11, T12, T13, T21, T22, T23) of the controller are provided on a pocket P-well, and
the bias circuit biases the pocket P-well to a lower voltage between a source voltage and a drain voltage of the charge transfer transistor (T10, T20).

12. The voltage generation circuit according to claim 10 or 11, wherein the charge transfer transistor (T10, T20) and the first through third transistors (T11, T12, T13, T21, T22, T23) are each a triple-well N-type transistor.

13. A voltage generation circuit comprising:
a first terminal (IN; NIO1);
a second terminal (OUT; NIO2); and
a plurality of charge pumps (1110, 1120; 1520, 1510; 2010, 2020; 2110, 2120) connected in series between the first terminal (IN; NIO1) and the second terminal (OUT; NIO2), each charge pump (1110, 1120; 2010, 2020; 2110, 2120) comprising a charge transfer transistor (T10, T20) and a controller that controls the charge transfer transistor (T10, T20),
wherein the voltage generation circuit (127; 127a; 127b; 127c) is bi-directional such that, when a negative voltage is applied to the first terminal (IN; NIO1), a negative voltage path is formed through the plurality of charge pumps (1110, 1120; 1520, 1510; 2010, 2020; 2110, 2120) and a voltage more negative than the negative voltage is output at the second terminal (OUT; NIO2), and when a positive voltage is applied to the second terminal (OUT; NIO2), a positive voltage path is formed through the plurality of charge pumps (1110, 1120; 1520, 1510; 2010, 2020; 2110, 2120) and a voltage more positive than the positive voltage is output at the first terminal (IN; NIO1).

14. The voltage generation circuit according to claim 13, further comprising a selector (1920, 1930) that selects the negative voltage path by applying the negative voltage to the first terminal (IN; NIO1), or the positive voltage path by applying the positive voltage to the second terminal (OUT; NIO2), according to a mode signal (MODE).

15. A voltage generation circuit comprising:
a plurality of charge pumps (1110, 1120; 1520, 1510; 2010, 2020; 2110, 2120) connected in series, each of the plurality of charge pumps (1110, 1120; 1520, 1510; 2010, 2020; 2110, 2120) comprising:
a charge transfer transistor (T10, T20) having a drain, a source that receives a first clock, and a gate that receives a second clock opposite to the first clock;
a controller coupled between the gate and the drain of the charge transfer transistor (T10, T20) and configured to offset electrons flowing into the gate of the charge transfer transistor (T10, T20) using feedback from an output of the charge transfer transistor (T10, T20); and
a bias circuit configured to bias the charge transfer transistor (T10, T20).

16. The voltage generation circuit according to claim 15, wherein the controller comprises:
a first transistor (T11, T21) having a source connected to a drain of the charge transfer transistor (T10, T20), a gate connected to the gate of the charge transfer transistor (T10, T20), and a drain connected to the gate of the charge transfer transistor (T10, T20);
a second transistor (T12, T22) having a source connected to the gate of the charge transfer transistor (T10, T20), a gate that receives the first clock, and a drain connected to the gate of the second transistor (T12, T22); and
a third transistor (T13, T23) having a source connected to the drain of the second transistor (T12, T22), a gate connected to the gate of the charge transfer transistor (T10, T20), and a drain connected to a drain of the charge transfer transistor.

17. The voltage generation circuit according to claim 16, further comprising:
a first capacitor (C11, C21) connected between the source of the charge transfer transistor (T10, T20) and the first clock;
a second capacitor (C12, C22) connected between the gate of the charge transfer transistor (T10, T20) and the second clock; and
a third capacitor (C13, C23) connected between the gate of the second transistor (T12, T22) and the second clock.

18. The voltage generation circuit according to any one of claims 15 to 17, wherein the bias circuit comprises:
a first bias transistor (T14, T24) having a drain, a source connected to a source of the charge transfer transistor (T10, T20), and a gate connected to the drain of the charge transfer transistor (T10, T20); and
a second bias transistor (T15, T25) having a source connected to the drain of the first bias transistor (T14, T24), a gate connected to the source of the first bias transistor (T14, T24), and a source connected to the drain of the charge transfer transistor (T10, T20).
